(19) **Europäisches Patentamt / European Patent Office / Office européen des brevets**

(11) **EP 1 184 999 B1**

(12) **FASCICULE DE BREVET EUROPEEN**

(45) Date de publication et mention
de la délivrance du brevet:
**15.10.2008 Bulletin 2008/42**

(51) Int Cl.:
**H04B 7/005** [(2006.01)]

(21) Numéro de dépôt: **01402025.9**

(22) Date de dépôt: **26.07.2001**

(54) **Procédé et dispositif de contrôle de l'amplification du signal émis par un terminal mobile permettant d'augmenter l'autonomie dudit terminal mobile**

Verfahren und Vorrichtung zur Regelung der Verstärkung eines aus einem Mobilfunkgerät gesendeten Signals zur Verlängerung der Batterielebensdauer

Method and device for adjusting the amplification of a signal transmitted by a mobile terminal in order to increase battery life

(84) Etats contractants désignés:
**AT BE CH CY DE DK ES FI FR GB GR IE IT LI LU MC NL PT SE TR**

(30) Priorité: **31.08.2000 FR 0011120**

(43) Date de publication de la demande:
**06.03.2002 Bulletin 2002/10**

(73) Titulaire: **TCL & ALCATEL MOBILE PHONES LIMITED**
**China Hong Kong City,**
**33 Canton Road,**
**Tsim Sha Tsui,Kowloon,**
**Hong Kong (CN)**

(72) Inventeurs:
• **Lagoguez, Bruno**
**92100 Boulogne Billancourt (FR)**
• **Brigaud, Jean Claude**
**95 Montreuil Sur Epte (FR)**
• **Pouliquen, Mikaël**
**75015 Paris (FR)**

(74) Mandataire: **Feray, Valérie et al**
**Feray Lenne Consult**
**39/41, avenue Aristide Briand**
**92163 Antony (FR)**

(56) Documents cités:
**EP-A- 0 392 079** **EP-A- 0 525 962**

**Description**

La présente invention concerne les terminaux sans fil, tels que les téléphones portables, et plus particulièrement un procédé ainsi qu'un dispositif de contrôle de l'amplification du signal émis par un terminal mobile permettant de réduire la consommation d'énergie de la batterie d'alimentation dudit terminal.

Les terminaux mobiles du type téléphones portables sont équipés d'un amplificateur de puissance permettant l'émission d'un signal de puissance suffisante lors des communications.

On sait que chaque téléphone, pour émettre et recevoir des appels, doit être constamment connecté à une borne. Plus le téléphone est éloigné de la borne, plus la puissance requise doit être importante.

D'après les spécifications du réseau GSM (Global System for Mobile communications), la puissance maximale que doit pouvoir émettre un terminal fonctionnant sur ce réseau doit être de 33 dBm. Cette puissance maximale peut être abaissée à 30.5 dBm en cas de conditions extrêmes, c'est-à-dire si la tension de la batterie est faible.

Ainsi, si le téléphone se trouve très éloigné de la borne à laquelle il est rattaché, celle-ci ci va réclamer au téléphone sa puissance maximale pour assurer un fonctionnement correct.

Cependant, plus la puissance émise doit être forte, plus l'amplification au niveau du terminal doit être importante et donc plus la batterie du terminal est sollicitée. Il s'ensuit une grande consommation d'énergie au niveau de la batterie et donc une importante réduction de l'autonomie du téléphone.

Dans ce contexte, la présente invention a pour objet de pallier cet inconvénient en proposant un procédé ainsi qu'un dispositif permettant d'amplifier un signal de terminal mobile tout en réduisant la consommation d'énergie de la batterie dudit terminal.

A cette fin, l'invention a pour objet un procédé de contrôle de l'amplification du signal émis par un terminal de radiocommunication selon la revendication 1.

Avantageusement, la valeur corrective est un multiple de (Vbat - Vnom), où (Vbat) est la tension de la batterie d'alimentation et (Vnom) sa tension nominale.

De préférence, au moins une des deux tensions détectée (Vdet) ou de consigne (Vref) n'est rendue dépendante de la tension (Vbat) de la batterie d'alimentation (10) que dans le domaine des puissances de sortie (Pout) de l'amplificateur (1) proches de 30 dBm.

L'invention concerne également un dispositif de contrôle de l'amplification du signal émis par un terminal comportant un amplificateur de puissance, tel que défini dans la revendication 5.

Selon une première forme de réalisation, les moyens de prise en compte de la tension de la batterie d'alimentation comprennent un soustracteur disposé entre les moyens de détection et de conversion de la puissance de l'amplificateur et les moyens de comparaison.

Avantageusement, le dispositif comporte en outre des moyens de blocage permettant de rendre une des deux tensions détectée (Vdet) ou de consigne (Vref) dépendante de la tension (Vbat) de la batterie d'alimentation (10) uniquement dans le domaine des puissances (Pout) de sortie de l'amplificateur proches de 30 dBm, lesdits moyens de blocage comprenant de préférence un transistor à effet de champ.

Selon une seconde forme de réalisation, les moyens pour rendre une des deux tensions détectée (Vdet) ou de consigne (Vref) dépendante de la tension (Vbat) de la batterie d'alimentation (10) comprennent des moyens logiciels uniquement dans le domaine des puissances (Pout) de sortie de l'amplificateur proches de 30 dBm.

L'invention porte, en outre, sur un terminal de radiocommunication comportant un dispositif de contrôle de l'amplification selon l'invention.

L'invention sera mieux comprise à la lumière de la description qui suit se rapportant à un exemple de réalisation illustratif mais en aucun cas limitatif, en référence aux dessins annexés dans lequel :

- La figure 1 est un schéma synoptique d'un dispositif permettant la mise en oeuvre d'un procédé de contrôle de l'amplification du signal émis par un terminal mobile selon l'art antérieur ;
- La figure 2 est un schéma synoptique d'une première forme de réalisation d'un dispositif permettant la mise en oeuvre du procédé selon l'invention ;
- La figure 3 est un schéma synoptique d'une seconde forme de réalisation d'un dispositif permettant la mise en oeuvre du procédé selon l'invention.

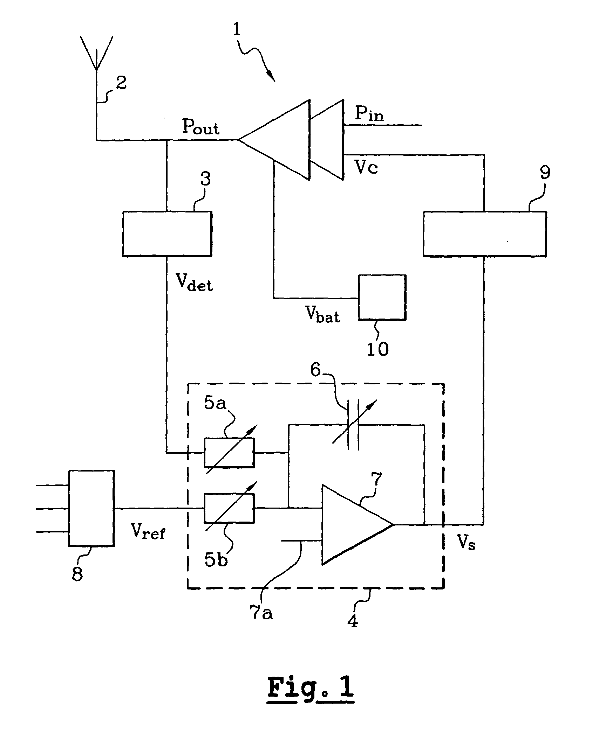

La figure 1 représente schématiquement un dispositif permettant la mise en oeuvre d'un procédé de contrôle de l'amplification du signal émis par un terminal mobile, tel qu'un téléphone portable, selon l'art antérieur.

L'amplification du signal se fait à travers un amplificateur de puissance 1 alimenté par une puissance d'entrée constante (Pin), provenant d'un préamplificateur (non représenté), et émettant une puissance de sortie (Pout) à travers l'antenne 2 du terminal mobile.

Le dispositif comporte également des moyens 3 de détection et de conversion de la puissance à la sortie de l'amplificateur de puissance 1. Les moyens 3 de détection détectent la puissance de sortie (Pout) de l'amplificateur de puissance 1 puis la convertissent en une tension (Vdet) correspondant à la tension détectée à la sortie des moyens 3 de détection et de conversion.

Ladite tension de sortie détectée (Vdet) est ensuite acheminée jusqu'à un comparateur 4, de type connu.

Ledit comparateur 4 comporte deux résistances variables 5a, 5b, dont les résistances respectives peuvent être identiques, un condensateur variable 6, ainsi qu'un amplificateur opérationnel 7 dont l'une des entrées 7a est reliée à la masse.

Les deux entrées du comparateur 4 sont donc constituées de la tension détectée (Vdet), image de la puissance (Pout) à la sortie de l'amplificateur de puissance 1, et d'une tension de consigne ou de référence, (Vref) issue de manière connue d'un convertisseur digital / analogique 8.

Selon le résultat de la comparaison entre (Vdet) et (Vref) effectuée par le comparateur 4, celui-ci délivre une tension de sortie (Vs) qui est acheminée jusqu'à des moyens de contrôle 9.

Lesdits moyens de contrôle 9 sont constitués d'un circuit de contrôle destiné à régler la tension contrôlée (Vc) à l'entrée de l'amplificateur de puissance 1 à partir de la tension de sortie (Vs) issue du comparateur 4.

Afin d'assurer son fonctionnement, l'amplificateur de puissance 1 est également alimenté par une batterie d'alimentation 10 délivrant une tension (Vbat).

Ainsi, selon l'amplification du signal à réaliser, l'amplificateur 1 sollicite plus ou moins la batterie d'alimentation 10. Dans le cas notamment où le terminal mobile se trouve éloigné de la borne fixe à laquelle il est rattaché, la puissance émise (Pout) doit être maximale, c'est-à-dire à 33 dBm selon les recommandations de la norme GSM.

Cette puissance maximale réclamée par la borne fixe entraîne une consommation importante d'énergie au niveau de la batterie d'alimentation 10 conduisant à une importante baisse de l'autonomie du terminal mobile.

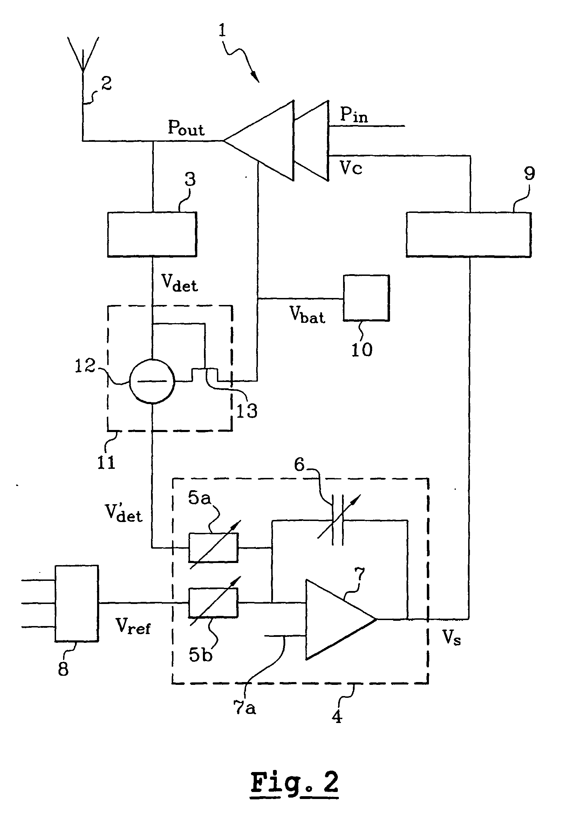

La figure 2 est une représentation schématique d'une première forme de réalisation d'un dispositif de contrôle de l'amplification du signal émis par un terminal mobile permettant de mettre en oeuvre le procédé selon l'invention.

Les éléments de la figure 2 identiques à ceux de la figure 1 conservent les mêmes références.

On retrouve ainsi l'amplificateur de puissance 1, les moyens 3 de détection et de conversion, le comparateur 4, le circuit de contrôle 9, ainsi que la batterie d'alimentation 10.

La différence essentielle avec les dispositifs de l'art antérieur se situe au niveau de la détection / conversion de la puissance de sortie (Pout) de l'amplificateur de puissance 1.

En effet, le dispositif selon l'invention comporte des moyens 11 aptes à prendre en compte la tension (Vbat) de la batterie d'alimentation 10 lors de la détection / conversion de la puissance de sortie de l'amplificateur de puissance 1.

Lesdits moyens 11 comportent un module de soustraction 12 ainsi que des moyens de blocage constitué, par exemple, d'un transistor à effet de champ 13. On entend par blocage le fait que, en dessous d'un certain seuil de puissance Pout, le transistor à effet de champ ne soit pas passant et bloque l'effet du soustracteur.

Le module de soustraction 12 ainsi que le transistor à effet de champ 13 sont tous deux reliés au circuit entre les moyens de détection 3 de la tension de sortie de l'amplificateur de puissance 1 et l'entrée du comparateur 4.

Le module de soustraction 12 est configuré de manière à délivrer une tension de sortie (V'det) telle que :

$$(V'det) = (Vdet) - K (Vbat - Vnom)$$

où :

- (Vdet) est la tension détectée immédiatement à la sortie des moyens de détection 3 ;

- K est un coefficient multiplicateur positif ;

- (Vnom) est la tension nominale de la batterie d'alimentation 10.

Ainsi, plus la tension (Vbat) de la batterie d'alimentation est faible, plus la différence (Vbat) - (Vnom) est importante.

La prise en compte de la tension (Vbat) de la batterie d'alimentation permet ainsi d'atténuer la différence entre la tension détectée à la sortie des moyens 3 de détection et de conversion et la tension de consigne (Vref).

Ainsi, les tensions (V'det) et (Vref) étant plus proches, l'amplification de puissance entre (Pin) et (Pout) est plus faible et la batterie d'alimentation 10 est moins sollicitée.

La batterie 10 étant moins sollicitée, son autonomie s'en trouve d'autant augmentée.

D'après les recommandations de la norme GSM, l'émission d'une puissance maximale inférieure à celle requise (33 dBm) est possible sous certaines conditions, notamment lorsque la tension de la batterie (Vbat) est faible.

Le transistor à effet de champ 13 permet de rendre le dispositif opérationnel uniquement pour une certaine gamme de puissance de sortie (Pout).

En effet, le transistor à effet de champ 13 n'est conducteur (et donc ne permet la prise en compte de la tension de la batterie (Vbat)) que pour des valeurs élevées de la puissance de sortie (Pout), telles que, par exemple, à partir de 30 dBm.

Grâce à cette configuration, la puissance de sortie (Pout) de l'amplificateur 1 dépend de la tension (Vbat) de la batterie 10 dès que le transistor 13 est rendu conducteur, c'est-à-dire dès que la puissance de sortie nécessaire (Pout) atteint un certain niveau.

Ainsi, pour des puissances de sortie (Pout) inférieures, le transistor 13 ne conduit pas : la tension (Vbat) de la batterie d'alimentation 10 n'est alors pas prise en compte et le dispositif fonctionne selon le procédé de l'art antérieur.

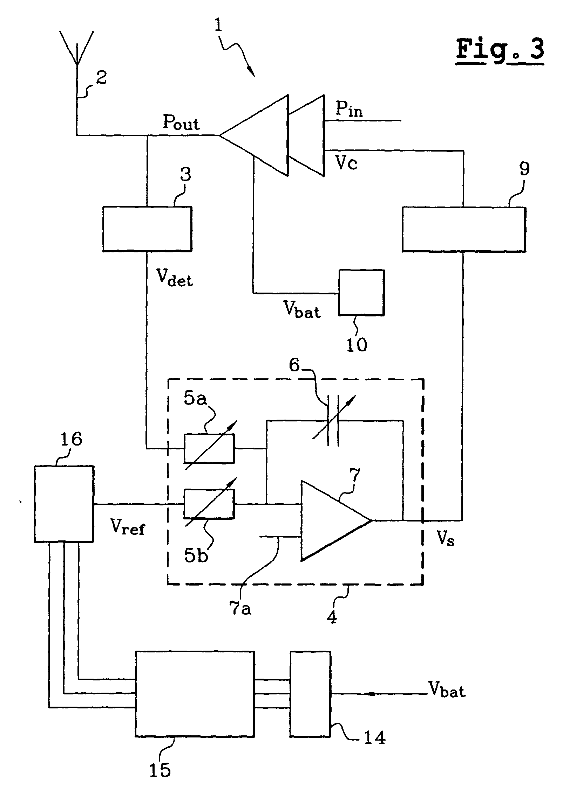

La figure 3 est une représentation schématique d'une seconde forme de réalisation d'un dispositif de contrôle de l'amplification du signal émis par un terminal mobile permettant de mettre en oeuvre le procédé selon l'invention.

A nouveau, les éléments identiques à ceux des figures 1 et 2 conservent les mêmes références.

Dans le cas de la figure 3, la prise en compte de la tension de la batterie d'alimentation (Vbat) se fait lors de l'établissement de la tension de consigne (Vref).

Ladite tension de la batterie d'alimentation (Vbat) passe par un convertisseur digital / analogique 14 puis des moyens logiciels 15, connus en eux-mêmes, vont établir une tension de consigne (Vref) à l'aide d'un algorithme, en fonction du niveau de la puissance de sortie (Pout) de l'amplificateur 1 et de la tension de la batterie d'alimentation (Vbat).

La tension détectée (Vdet) reste, dans cette forme de réalisation, inchangée.

De façon simplifiée, l'algorithme des moyens logiciels 15 peut, par exemple, être du type :

Si

$$(Pout) > (Plim),$$

Alors

$$(Vref)' = (Vref) + K'(Vbat - Vnom)$$

Où:

(Plim) est une valeur limite de la puissance de sortie (Pout) de l'amplificateur 1, choisi par le constructeur,

. (Vref) est la tension de consigne lorsque la tension de la batterie (Vbat) n'est pas prise en compte (donc lorsque (Pout) < (Plim)),

. K' est un coefficient multiplicateur positif ;

. (Vnom) est la tension nominale de la batterie d'alimentation 10.

Un autre convertisseur digital / analogique 16, à la sortie des moyens logiciels 15, afin d'obtenir la tension (Vref) ou (Vref)', lesdits moyens logiciels 15 n'opérant pas réellement sur des tensions mais permettant de les commander.

Ainsi, à partir d'une valeur limite (Plim) de la puissance de sortie (Pout) de l'amplificateur 1, la tension de consigne (Vref) prend une valeur (Vref)' dépendant de la tension de la batterie (Vbat).

Le coefficient K' étant choisi positif, la tension modifiée (Vref)' est inférieure à (Vref), ce qui permet, comme dans le cas de la première forme de réalisation, de réduire l'écart entre la tension détectée (Vdet) et la tension de consigne (Vref)'.

Cet écart étant réduit, l'amplification entre la puissance d'entrée (Pin) et la puissance de sortie (Pout) est plus faible.

La batterie d'alimentation 10 est donc moins sollicitée, augmentant son autonomie.

Ainsi, pour des fortes puissances (à partir par exemple de 30 dBm), le dispositif prend en compte la tension (Vbat) de la batterie d'alimentation 10 afin de limiter l'amplification de la puissance permettant une économie d'énergie de la batterie d'alimentation 10.

Un autre avantage du dispositif et du procédé selon l'invention, est qu'ils permettent d'éviter la saturation de l'amplificateur de puissance 1 lorsque le terminal mobile se trouve, par exemple, relativement proche de la borne fixe à laquelle il est rattaché.

## Revendications

1. Procédé de contrôle de l'amplification du signal émis par un terminal de radiocommunication comportant un amplificateur de puissance (1) et une batterie d'alimentation (10) de tension (Vbat), ledit procédé comprenant les étapes de :

   - détection (3) de la puissance de sortie (Pout) de l'amplificateur (1) et conversion de cette puissance (Pout) en tension détectée (Vdet),
   - comparaison (4) de ladite tension détectée (Vdet) avec une tension de consigne (Vref),
   - adaptation(9) de la tension d'entrée (Vc) de l'amplificateur de puissance (1) selon le résultat de la comparaison,

   **caractérisé en ce**,
   avant l'étape de comparaison de la tension détectée (Vdet) avec la tension de consigne (Vref), on réduit l'écart entre la tension détectée (Vdet) et la tension de consigne (Vref) soit en augmentant la tension détectée (Vdet) soit en diminuant la tension de consigne (Vref) d'une valeur corrective dépendant de la tension (Vbat) de la batterie d'alimentation (10).

2. Procédé selon la revendication 1, **caractérisé en ce que** la valeur corrective est un multiple de (Vbat - Vnom), où (Vnom) est la tension nominale de la batterie d'alimentation (10).

3. Procédé selon l'une des revendications précédentes, **caractérisé en ce que** la réduction de l'écart n'est réalisée que dans un domaine limité de puissance de sortie (Pout) de l'amplificateur (1).

4. Procédé selon la revendication précédente, **caractérisé en ce que** la réduction de l'écart n'est réalisée que dans le domaine des puissances de sortie (Pout) de l'amplificateur (1) proches de 30 dBm.

**5.** Dispositif de contrôle de l'amplification du signal émis par un terminal comportant un amplificateur de puissance (1), des moyens (3) de détection de la puissance (Pout) à la sortie dudit amplificateur (1) et de conversion de cette puissance (Pout) en tension détectée (Vdet), des moyens de comparaison (4) de la tension détectée (Vdet) avec une tension de consigne (Vref), des moyens de contrôle (9) de la tension d'entrée (Vc) de l'amplificateur (1) ainsi qu'une batterie d'alimentation (10) de tension (Vbat), **caractérisé en ce qu'**il comporte des moyens (11) de réduction de l'écart entre la tension détectée et la tension de consigne pour délivrer aux moyens de comparaison (4) une tension détectée (Vdet) augmentée ou une tension de consigne (Vref) diminuée d'une valeur corrective dépendante de la tension (Vbat) de la batterie d'alimentation (10).

**6.** Dispositif selon la revendication 5, **caractérisé en ce que** les moyens (11) de réduction d'écart comprennent un soustracteur (12) disposé entre les moyens (3) de détection et de conversion de la puissance (Pout) et les moyens de comparaison (4).

**7.** Dispositif selon l'une des revendications 5 ou 6, **caractérisé en ce qu'**il comporte en outre des moyens de blocage (13) permettant de rendre les moyens (11) de réduction d'écart opérationnels uniquement dans le domaine des puissances de sortie (Pout) de l'amplificateur (1) proches de 30 dBm.

**8.** Dispositif selon la revendication précédente, **caractérisé en ce que** les moyens de blocage comprennent un transistor à effet de champ (13).

**9.** Dispositif selon la revendication 5, **caractérisé en ce que** les moyens (11) de réduction d'écart comprennent des moyens logiciels (15).

**10.** Dispositif selon la revendication précédente, **caractérisé en ce que** les moyens logiciels (15) sont utilisés uniquement dans le domaine des puissances (Pout) proches de 30 dBm.

**11.** Terminal de radiocommunication **caractérisé en ce qu'**il comporte un dispositif selon l'une des revendications 5 à 10.

**Claims**

**1.** A method for controlling the amplification of the signal emitted by a radiocommunication terminal, comprising a power amplifier (1) and a power supply battery (10) having a voltage (Vbat), said method comprising the steps of:

- detecting (3) the output power (Pout) of the amplifier (1) and converting this power (Pout) into a detected voltage (Vdet),
- comparing (4) said detected voltage (Vdet) with a reference voltage (Vref),
- adapting (9) the input voltage (Vc) of the power amplifier (1) according to the result of the comparison,

**characterized in that** before the step of comparing the detected voltage (Vdet) with the reference voltage (Vref), the difference between the detected voltage (Vdet) and the reference voltage (Vref) is reduced, by either increasing the detected voltage (Vdet) or by decreasing the reference voltage (Vref) by a corrective value depending on the voltage (Vbat) of the power supply battery (10).

**2.** The method according to claim 1, **characterized in that** the corrective value is a multiple of (Vbat - Vnom), with (Vnom) the nominal voltage of the power supply battery (10).

**3.** The method according to any of the preceding claims, **characterized in that** reducing the difference is performed only in a limited output power (Pout) range of the amplifier (1).

**4.** The method according to the preceding claim, **characterized in that** reducing the difference is performed only in the output power (Pout) range of the amplifier (1) close to 30 dBm.

**5.** A device for controlling the amplification of the signal emitted by a terminal, comprising a power amplifier (1), means (3) for detecting the output power (Pout) at the output of said amplifier (1) and converting this power (Pout) into a detected voltage (Vdet), means for comparing (4) the detected voltage (Vdet) with a reference voltage (Vref), means for controlling (9) the input voltage (Vc) of the amplifier (1), as well as a power supply battery (10) having a voltage (Vbat), **characterized in that** it comprises means (11) for reducing the difference between the detected voltage and the reference voltage in order to output to the comparison means (4) either a detected voltage (Vdet) increased or a reference voltage (Vref) decreased by a corrective value depending on the voltage (Vbat) of the power supply battery (10).

**6.** The device according to claim 5, **characterized in that** the means (11) for reducing the difference comprises a subtractor (12) arranged between the means (3) for detecting and converting the power (Pout) and the comparison means (4).

**7.** The device according to any of claims 5 or 6, **characterized in that** it further comprises locking means (13) allowing the means (11) for reducing the difference to be made operational only in the range of output powers (Pout) of the amplifier (1) close to 30 dBm.

**8.** The device according to the preceding claim, **characterized in that** the locking means comprises a field effect transistor (13).

**9.** The device according to claim 5, **characterized in that** the means (11) for reducing the difference comprises software means (15).

**10.** The device according to the preceding claim, **characterized in that** the software means (15) is used only in the range of the powers (Pout) close to 30 dBm.

**11.** Radiocommunication terminal, **characterized in that** it comprises a device according to any of claims 5 to 10.

**Patentansprüche**

**1.** Verfahren zur Steuerung der Verstärkung des Signals, das von einem Funkendgerät ausgesendet wird, umfassend einen Leistungsverstärker (1) und eine Versorgungsbatterie (10) der Spannung (Vbat), wobei das Verfahren folgende Schritte umfasst:

- Erfassen (3) der Ausgangsleistung (Pout) des Verstärkers (1) und Umformen dieser Leistung (Pout) in eine erfasste Spannung (Vdet),
- Vergleichen (4) der erfassten Spannung (Vdet) mit einer Referenzspannung (Vref),
- Anpassen (9) der Eingangsspannung (Vc) des Leistungsverstärkers (1) gemäß dem Vergleichsergebnis,

**dadurch gekennzeichnet, dass** vor dem Schritt des Vergleichens der erfassten Spannung (Vdet) mit der Referenzspannung (Vref) die Abweichung zwischen der erfassten Spannung (Vdet) und der Referenzspannung (Vref) reduziert wird, entweder durch Erhöhen der erfassten Spannung (Vdet) oder durch Verringern der Referenzspannung (Vref) um einen Korrekturwert, der von der Spannung (Vbat) der Versorgungsbatterie (10) abhängig ist.

**2.** Verfahren nach Anspruch 1, **dadurch gekennzeichnet, dass** der Korrekturwert ein Vielfaches von (Vbat - Vnom) ist, wobei (Vnom) die Nennspannung der Versorgungsbatterie (10) ist.

**3.** Verfahren nach einem der vorhergehenden Ansprüche, **dadurch gekennzeichnet, dass** die Reduzierung der Abweichung nur in einem begrenzten Bereich der Ausgangsleistung (Pout) des Verstärkers (1) erfolgt.

**4.** Verfahren nach dem vorhergehenden Anspruch, **dadurch gekennzeichnet, dass** die Reduzierung der Abweichung nur in dem Bereich der Ausgangsleistungen (Pout) des Verstärkers (1) im Nahbereich von 30 dBm erfolgt.

**5.** Vorrichtung zur Steuerung der Verstärkung des Signals, das von einem Endgerät ausgesendet wird, umfassend einen Leistungsverstärker (1), Mittel (3) zum Erfassen der Ausgangsleistung (Pout) am Ausgang des Verstärkers (1) und zum Umformen dieser Leistung (Pout) in eine erfasste Spannung (Vdet), Mittel zum Vergleichen (4) der erfassten Spannung (Vdet) mit einer Referenzspannung (Vref), Mittel zur Steuerung (9) der Eingangsspannung (Vc) des Verstärkers (1), sowie eine Versorgungsbatterie (10) der Spannung (Vbat),
**dadurch gekennzeichnet, dass** sie Mittel (11) umfasst zum Reduzieren der Abweichung zwischen der erfassten Spannung und der Referenzspannung, um an die Vergleichsmittel (4) entweder eine erhöhte erfasste Spannung (Vdet) oder eine verringerte Referenzspannung (Vref), jeweils um einen Korrekturwert K, der von der Spannung (Vbat) der Versorgungsbatterie (10) abhängt, abzugeben.

**6.** Vorrichtung nach Anspruch 5, **dadurch gekennzeichnet, dass** die Mittel (11) zum Reduzieren der Abweichung ein Subtrahierglied (12) umfassen, das zwischen den Mitteln (3) zum Erfassen und Umformen der Leistung (Pout) und den Vergleichsmitteln (4) angeordnet ist.

**7.** Vorrichtung nach einem der Ansprüche 5 oder 6, **dadurch gekennzeichnet, dass** sie ferner Sperrmittel (13) umfasst, die es ermöglichen, die Mittel (11) zum Reduzieren der Abweichung nur im Bereich der Ausgangsleistungen (Pout) des Verstärkers (1) im Nahbereich von 30 dBm betriebsfähig zu machen.

**8.** Vorrichtung nach dem vorhergehenden Anspruch, **dadurch gekennzeichnet, dass** die Sperrmittel einen Feldeffekttransistor (13) umfassen.

**9.** Vorrichtung nach Anspruch 5, **dadurch gekennzeichnet, dass** die Mittel (11) zum Reduzieren der Abweichung Softwaremittel (15) umfassen.

**10.** Vorrichtung nach dem vorhergehenden Anspruch, **dadurch gekennzeichnet, dass** die Softwaremittel (15) nur in dem Bereich der Leistungen (Pout) im Nahbereich von 30 dBm verwendet werden.

**11.** Funkendgerät, **dadurch gekennzeichnet, dass** es eine Vorrichtung nach einem der Ansprüche 5 bis 10 umfasst.

**<u>Fig. 1</u>**

**Fig. 2**

**Fig. 3**